Europäisches Patentamt

European Patent Office

Office européen des brevets

(19)

(11) Publication number: **0 146 272**
A2

# (12) EUROPEAN PATENT APPLICATION

(21) Application number: **84308049.0**

(22) Date of filing: **21.11.84**

(51) Int. Cl.⁴: **H 01 B 11/18,** H 01 B 13/00

(30) Priority: **22.11.83 GB 8331157**

(43) Date of publication of application: **26.06.85**
**Bulletin 85/26**

(84) Designated Contracting States: **AT BE CH DE FR IT LI NL SE**

(71) Applicant: **RAYCHEM LIMITED, Rolls House 7, Rolls Buildings Fetter Lane, London, EC4 1NL (GB)**

(72) Inventor: **Booth, Michael, 83 Dunnington Road, Wootton Bassett, Swindon Wiltshire (GB)**

(74) Representative: **Dlugosz, Anthony Charles et al, Raychem Limited Intellectual Property Law Department Faraday Road, Dorcan Swindon Wiltshire (GB)**

(54) Coaxial cable.

(57) A piezoelectric coaxial cable comprises a central stretchable conductor (1), an outer electrical conductor (3) and an intermediate insulating layer (2), preferably formed from polyvinylidine fluoride, which has been stretched and radially polarized to render it piezoelectric. The central conductor is also stretched when the intermediate insulating layer is stretched and is preferably formed from a low melting point metal which can be fused in order to allow it to be stretched.

The central conductor has a relatively high tensile modulus, e.g. at least 0.45 GPa, or no smaller than 1.65 GPa below the tensile modulus of the intermediate layer, because it has been found that the piezoelectric response of such cables increases as the tensile modulus of the central conductor increases.

EP 0 146 272 A2

This invention relates to coaxial cables and in particular to piezoelectric coaxial cables.

A number of piezoelectric coaxial cables have hitherto been proposed. Such cables comprise a central electrical conductor, an intermediate insulating layer of piezoelectric material surrounding the central conductor, and an outer electrical conductor surrounding the intermediate layer. Piezoelectric coaxial cables have often been proposed for use as transducers since, when they are subjected to an applied pressure, for example caused by impact by an object or acoustic pressure changes, a potential difference will be generated between the electrodes by the piezoelectric material.

In recent years certain polymeric materials, for example polyvinylidine fluoride and vinylidine fluoride copolymers have been suggested for use as piezoelectric materials. In order to maximize the piezoelectric properties of a vinylidine fluoride polymer, it is necessary to orient the polymer by stretching it, preferably up to its "natural" draw ratio of about 4:1 or beyond, in order to convert at least a portion of the polymer from its initial $\alpha$ or form II crystalline form into its $\beta$ phase or form I. Simultaneously with, or subsequent to, the stretching operation, it is necessary to polarize the polymer by applying a high electric field gradient across the polymer in a direction perpendicular to the direction of orientation in order to align the dipoles in the form I phase of the polymer. Electric field gradients of from 5 to 200 $MVm^{-1}$ are typical for the polarizing operation, the maximum applied field gradient usually being determined by dielectric break-down of the polymer material. In the case of piezoelectric materials that are in sheet form, the electrodes used for the polarizing operation may be metal layers that have been deposited after the material has been stretched or, if the sheet is stretched in the nip of a pair of rollers, the rollers themselves may be used as the electrodes. Alternatively, corona discharge electrodes may be used on one or both sides of the sheet, for example as described in U.S. Patent Specification No. 4,308,370.

In the case of a piezoelectric coaxial cable, in order to maximize its piezoelectric response, the intermediate layer would need to be stretched axially and polarized radially between an inner, central, electrode and an outer electrode. While the outer electrode may be applied to the intermediate layer after stretching, or, if a corona poling method is employed, the cable may be passed through a corona discharge electrode and an outer electrical conductor for the cable be subsequently provided, significant problems are encountered in the provision of an internal electrode or conductor for the cable: it is not possible to extrude the intermediate layer onto a conventional metal conductor, e.g. a copper conductor, in that it would then be impossible subsequently to stretch the intermediate layer in order to convert it into form I. Thus, in order to form a piezoelectric cable having a high piezoelectric response and using a polymeric piezoelectric intermediate layer, it is necessary for the central conductor either to be stretchable with the intermediate layer or to be capable of being inserted into the intermediate layer after stretching. This requirement severely limits the number of suitable materials for the central conductor.

According to one aspect, the present invention provides a piezoelectric coaxial cable, which comprises a central electrical conductor, an outer electrical conductor, and an intermediate insulating layer comprising a polymeric material that has been axially stretched and radially polarized to render it piezoelectric, the central conductor having a melting point below the melting or softening point of the intermediate layer and a tensile modulus of at least 0.45 GPa.

According to another aspect, the invention provides a piezoelectric coaxial cable, which comprises a central electrical conductor, an outer electrical conductor, and an intermediate layer comprising a polymeric material, the central conductor and the intermediate layer having been axially stretched and the intermediate layer having been radially polarized to render it piezoelectric, the central conductor having a tensile modulus of at least 0.45 GPa.

It has been found that almost all the materials that are suitable for forming the central electrical conductor given the requirement mentioned above have tensile (Young's) moduli that are very low, usually significantly below the value of the tensile modulus of the polymeric material that is used. This is particularly true if the central conductor is sufficiently flexible to allow flexing of the cable, since it is not possible to increase the flexibility of the conductor by stranding as is the case with conventional wires. It has also been found that, when such materials are used as the central conductor, it is possible to increase the hydrostatic piezoelectric charge response of the coaxial cable significantly by increasing the tensile modulus of the central conductor. Therefore, the central conductor preferably has a tensile modulus of at least 0.5, e.g. at least 0.6, more preferably at least 0.8, e.g. at least 1.0 GPa, and especially at least 1.5 GPa, e.g. at least 2.0 GPa.

The tensile modulus of the intermediate layer will depend on the particular polymer that is used to form it and also on the processing conditions used in the manufacture of the cable. Preferably the central conductor has a tensile modulus no smaller than 2.25 GPa below, more preferably no smaller than 2.0 GPa below, and most preferably no smaller than 1.65 GPa below, the tensile modulus value of the intermediate layer.

Thus, according to a further aspect, the invention provides a piezoelectric coaxial cable, which comprises a central electrical conductor, an outer electrical conductor, and an insulating intermediate layer comprising a polymeric material that has been axially stretched and radially polarized to render it piezoelectric, the central conductor having a melting point below the melting or softening point of the intermediate layer and having a tensile modulus no smaller than 1.65 GPa below the tensile modulus of the intermediate layer.

According to yet another aspect, the invention provides a piezoelectric coaxial cable, which comprises a central electrical conductor, an outer electrical conductor, and an intermediate layer comprising a polymeric piezoelectric material, the central conductor and the intermediate layer having been axially stretched and the intermediate layer having been radially polarized to render it piezoelectric, the central conductor having a minimum tensile modulus value of 1.65 GPa below the tensile modulus of the intermediate layer.

The preferred conductors will have a tensile modulus no smaller than 1.2 GPa below, more preferably no smaller than 1 GPa below and especially no smaller than 0.5 GPa below the tensile modulus of the intermediate layer. It is preferred, if posible, for the central conductor to have a tensile modulus that is higher than that of the intermediate layer.

Although the cable is described herein as a "coaxial cable", this term is not intended to imply that the central conductor and the outer conductor must be exactly concentric, but rather it is intended to mean that the central conductor is surrounded by, and insulated from, the outer conductor by the intermediate layer. It will be appreciated by those skilled in the art that some deviation from absolute concentricity is the rule in coaxial cables, and in some cases this may be intended.

The intermediate layer may be formed from any material that can be rendered piezoelectric by orientation and polarizing. Such materials include nylon 5, nylon 7, polyhydroxybutyrate, vinylidine cyanide/vinyl acetate copolymers and vinylidine fluoride polymers. The term "vinylidine fluoride polymer" is intended to include polyvinylidine fluoride, commonly abbreviated to "PVDF" or "$PVF_2$" and those copolymers of vinylidine fluoride in which a piezoelectric activity

0146272

may be generated or enhanced by orientation and polarizing. Suitable copolymers include copolymers and terpolymers of vinylidine fluoride with vinyl fluoride, trifluoroethylene, tetrafluoroethylene, vinyl chloride, and chlorotrifluoroethylene. In addition, blends of vinylidine fluoride polymers with other polymers, e.g. polymethylmethacrylate, are included provided that the piezoelectric activity thereof is not destroyed. Preferably the intermediate layer comprises a vinylidine fluoride polymer, more preferably polyvinylidine fluoride and especially it consists substantially solely of polyvinylidine fluoride.

Preferably the central conductor comprises a low melting point metal so that the central conductor and the intermediate layer can be heated to melt the metal and then stretched while the metal is still liquid. In theory any metal having a melting point that is sufficiently low to allow the metal to melt without thermally degrading or melting the intermediate layer may be used, although, because the modulus of such metals, in general, increases with their melting point, it is desirable to select a metal having as high a melting point as possible having regard to the softening point of the intermediate layer and having regard to the preferred stretching temperature. Preferably the metal has a melting point of not more than 170°C, more preferably not more than 160°C and especially not more than 150°C. Also it is preferred for the metal to have a melting point of at least 50°C, more preferably at least 60°C, especially at least 65°C and most especially at least 70°C. The metal forming the central conductor may be formed from an alloy having a eutectic composition in which case it will exhibit a single, well defined, melting point, or it may be formed from a non-eutectic alloy, in which case the metal may enter a phase between the solidus and liquidus lines of its phase diagram in which its ductility increases with temperature.  It is not necessary for the metal to melt completely for the stretching operation, provided that it becomes sufficiently ductile that it will not fracture.

In some instances, where it is possible to employ metals having melting points below about 100°C, it may be desirable to use bismuth containing alloys that expand as they solidify from the melt.

Examples of low melting point alloys that may be used for the central conductor are shown in Table I.

## TABLE I

| Alloy | Components (percent by weight) | | | | | Melting |
| Number | Bi | Sn | Pb | Cd | In | Point (°C) |
| --- | --- | --- | --- | --- | --- | --- |
| 1 | 49 | 15 | 18 | | 18 | 58-69 |
| 2 | 50 | 13 | 27 | 10 | | 70-73 |
| 3 | 57 | 17 | | | 26 | 79 |
| 4 | 38 | 15 | 31 | 16 | | 70-97 |
| 5 | | 50 | | | 50 | 118-125 |
| 6 | | 51 | 31 | 18 | | 143 |
| 7 | | 54 | 26 | | 20 | |

Preferably, at least if the central conductor has a tensile modulus that is less than that of the intermediate layer, the radius of the central conductor is relatively small with respect to the external radius of the intermediate layer since it has been observed that decreasing the radius of the central conductor in relation to the external radius of the intermediate layer also increases the hydrostatic piezoelectric charge response of the cable. A further advantage of reducing the radius of the central conductor, and hence the internal radius of the intermediate layer, is that it enables such coaxial cables, and especially those having an intermediate layer with a relatively thick wall, to be manufactured by a continuous process, as described in our co-pending U.K Patent Application No.              entitled "Coaxial Cable" and filed on even date herewith (Agent's reference RK218) the disclosure of which is incorporated herein by reference. Thus, for example, the radius of the central conductor is preferably not more than 0.5 times, more preferably not more than 0.4 times, especially not more than 0.35 times, e.g. less than 0.33 times, and most especially 0.3 times the external radius of the intermediate layer, although it will, for practical reasons, usually be at least 0.1 times, and more usually at least 0.2 times the external radius of the intermediate layer. Preferably the wall thickness of the intermediate layer is at least 0.2mm, more preferably at least 0.3mm, especially at least 0.4mm, and most especially at least 0.5mm in order to increase the piezoelectric sensitivity of the cable.

According to another aspect, the invention provides a method of forming a piezoelectric coaxial cable, which comprises the steps of:

0146272

(a)     forming a wire comprising a central electrical
        conductor that is capable of being stretched and
        has a tensile modulus of at least 0.45 GPa, the
        central conductor being surrounded by an insulating polymeric layer comprising a material
        that is capable of being rendered piezoelectric
        by being oriented and polarized;

(b)     axially stretching the wire to orient the insulating layer;

(c)     simultaneously with, or subsequent to, step (b),
        radially polarizing the insulating layer;
        and

(d)     providing the stretched wire with an outer
        electrical conductor.

        According to yet another aspect, the invention
provides a method of forming a piezoelectric coaxial
cable, which comprises the steps of :

(a)     forming a wire comprising a central electrical
        conductor that is capable of being stretched
        and, surrounding the central conductor, an
        insulating layer comprising a material that is
        capable of being rendered piezoelectric by being
        oriented and polarized;

(b)     axially stretching the wire to orient the insulating layer and to form a wire in which the
        central conductor has a tensile modulus no
        smaller than 1.65 GPa below the tensile modulus
        of the oriented insulating layer;

(c)     simultaneously with, or subsequent to, step (b),
        radially polarizing the insulating layer:
        and

(d)     providing the stretched wire with an outer
        electrical conductor.

The dimensions of the resulting cable are preferably as described above. Since the absolute value of
the wall thickness of the cable decreases as the
conductor and intermediate layer are stretched, the
intermediate layer preferably has a wall thickness
prior to stretching of at least 0.3, more preferably at
least 0.5, especially at least 0.8 and most especially
at least 1.0mm.

The preferred materials for forming the insulating
layer and the central conductor are those described
above.

The wire should be heated to an elevated temperature before it is stretched in order to melt the
central conductor, if a low melting point metal is
used, and to raise the insulating layer to a suitable
stretching temperature, e.g. a temperature in the range
of from 50 to 170°C, preferably from 60 to 150°C and
especially from 80 to 130°C. Preferably the process is
conducted so that the inner portion of the insulating
layer is at a higher temperature than the outer portion
thereof. Not only does such a temperature difference
across the insulating layer allow the use of somewhat
higher melting point metals without the polymer temperature being too high for effective conversion to form
I, but also it is currently believed that this may assist the radial contraction of the insulating layer when the wire is stretched, thereby reducing the possibility of void formation within the central conductor or between the central conductor and the insulating layer. This may conveniently be achieved either by allowing the wire to cool for a number of seconds after it has been heated, or by first heating the wire in a heating bath or hot air zone followed by a short period of forced cooling.

Preferably the wire is stretched to the "natural" draw ratio of the insulating layer if such a ratio exists, for example about 3.5 to 4.5 times its original length in the case of a vinylidine fluoride polymer, although it is possible to stretch the wire to a lesser or greater extent if desired.

The stretched wire may be provided with an outer electrical conductor either before or after the insulating layer has been polarized. Thus, for example, the wire may be stretched, provided with a deposited metal outer conductor and then polarized by application of a high D.C. potential to the inner and outer conductors. Preferably, however, the outer electrical conductor is provided after the insulating layer has been polarized, in which case the insulating layer is preferably polarized by means of a corona discharge; the wire being passed through an annular corona discharge electrode while the other electrode for the polarizing operation is provided by the central conductor. If the outer conductor is provided after the polarizing step, it is convenient for the stretching step (b) and the polarizing step (c) to be conducted substantially simultaneously, that is to say, so that at least part of the polarizing step coincides with at least part of the stretching step. It is not necessary for both steps to have the same duration: it may be desirable for polarization (commonly referred to as "poling") to carry on after stretching has been completed.

In the preferred method at least the stretching step (b) and the polarizing step (c) are conducted as a continuous process in which wire formed in step (a) of indefinite length is passed through a heating zone in which the wire is heated to a predetermined elevated temperature, and the heated wire is passed through a stretching zone and a polarizing zone and then through a cooling zone, such that, at any instant, only a portion of the wire is at or above the predetermined elevated temperature.

The stretching zone and the polarizing zone may occur at different positions along the path of the wire so that it is stretched and poled sequentially, or they may occur in the same position so that stretching and polarizing occur simultaneously. When polyvinylidine fluoride is stretched to its natural draw ratio in a continuous process, it is observed to "neck" at a certain point, that is to say, the lateral dimensions abruptly decrease at a particular point as it is stretched. It is preferred for the wire to be polarized at the point at which it necks.

Another advantage of the invention is that it enables a piezoelectric coaxial cable to be formed in

0146272

which the intermediate piezoelectric layer is substantially free of voids.

Preferably the wire is formed in step (a) by co-extruding the central conductor and the insulating layer so that long lengths of wire may be formed. The stretching and polarizing steps may be conducted immediately after the wire has been formed or it may be spooled and stored before stretching and polarizing.

The outer electrical conductor may be provided by a number of means in known manner. For example it may be painted on using a metal paint or a metal may be deposited by an electroless deposition method, for example as described in U.S. Patent No. 4,180,602, the disclosure of which is incorporated herein by reference. Other methods include evaporation, sputtering techniques, or ion beam plating.

A coaxial cable and a method of forming it will now be described by way of example with reference to the accompanying drawings, in which:

Figure 1 is an isometric view of part of a coaxial cable according to the invention;

Figure 2 is a schematic view of the formation of unstretched wire; and

Figire 3 is a schematic view of the stretching and polarizing of the wire.

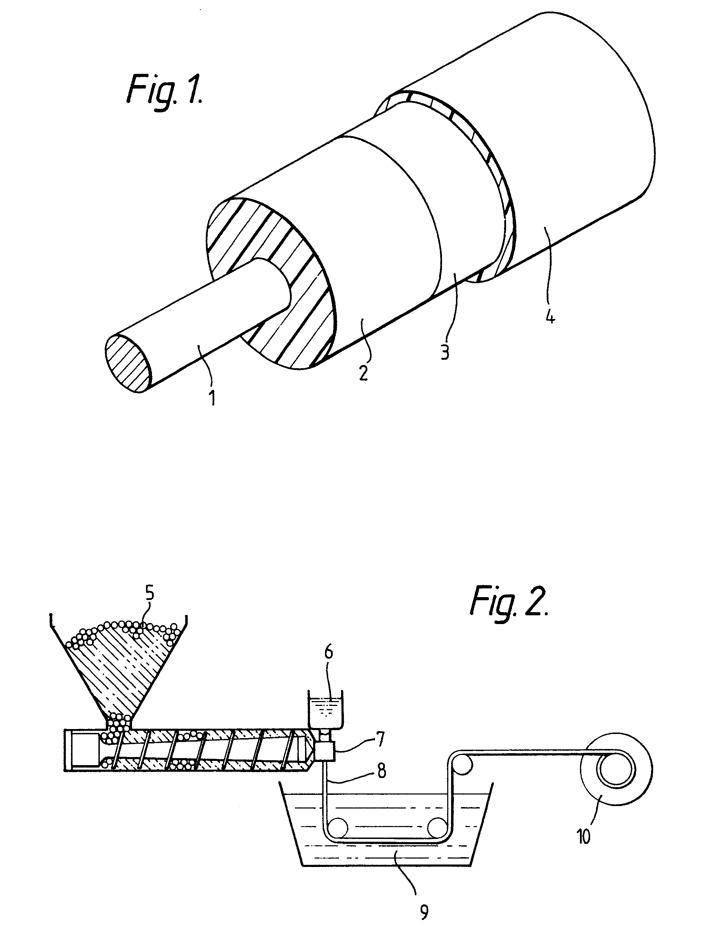

Referring to figure 1 a piezoelectric coaxial cable comprises a central conductor 1 formed from one of the alloys shown in table I, an intermediate insulating layer 2 formed from polyvinylidine fluoride and an outer conductive layer 3 formed from silver paint. The radius of the central conductor, and therefore the internal radius of the insulating layer being 0.3 times the external radius of the insulating layer.

The cable may optionally be provided as shown with a polymeric jacket 4, for example formed from polyvinylidine fluoride, polyethylene, ethylene vinyl acetate copolymers and the like.

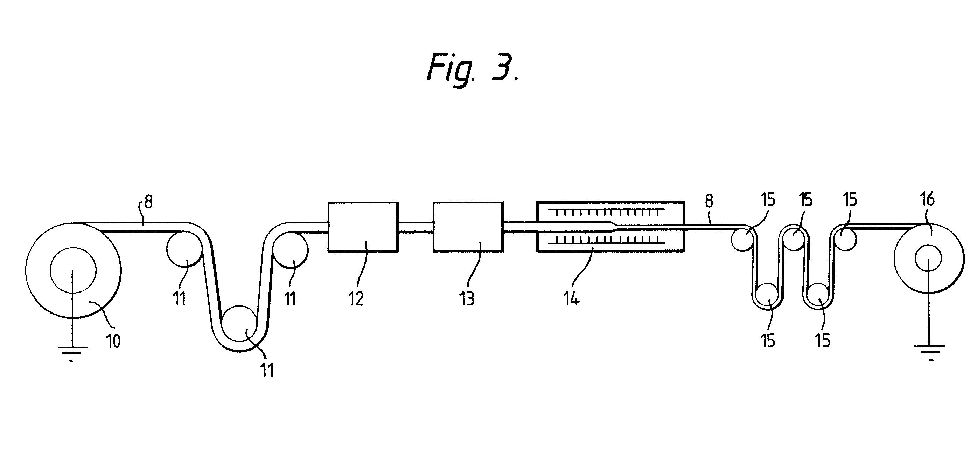

Figures 2 and 3 show schematically the formation of the wire and then stretching and polarizing it. Polyvinylidine fluoride pellets 5 and low melting point metal alloy 6 are fed into an extruder fitted with a co-extrusion die 7. The die 7 is designed so that the internal and external radii of the polyvinylidine fluoride layer will have the appropriate ratio. As soon as the wire 8 is formed it is passed through a cooling bath 9 and quenched to ambient temperature and is then wound onto a take-up spool 10. The leading end of the wire 8 is kept accessible as the wire is wound onto the spool 10.

The spool 10 is then used as a feed spool in the next stage of the process shown in figure 3. The wire is taken off spool 10, passed through feed rollers 11, heating zone 12, cooling zone 13, temperature controlled polarizing zone 14, traction rollers 15 and then to take-up spool 16. The central conductor 1 is electrically connected to both the spool 10 and the spool 16 which are earthed. The traction rollers 15 are adjusted so that their peripheral speed is four times that of the feed rollers 11, thereby causing the wire 4 to stretch by 4:1 as it passes between them. As the wire leaves the feed rollers 11 it passes through a heating zone 12 in the form of a glycerine bath which heats the wire to a uniform temperature in the range of from 100 to 170°C depending on the metal used for the central conductor. The heated wire passes through a cooling zone 13 in which it is briefly cooled by cold air to reduce the temperature of the external surface of the wire by about 20 to 50°C, and then, optionally via pinch rollers (not shown), through the polarizing zone 14 in which it is subjected to a 60 kV corona discharge. The polarizing zone is so located, and its temperature is so adjusted, that the wire necks down at this stage. After having been polarized, the wire 4 passes through the traction rollers 15 which are maintained at ambient temperature and so cool the wire, and the wire is then taken up by the take-up spool 16.

After this process the wire is ready to have an outer conductor deposited thereon in known manner. For example, an aluminium layer of about 50 to 60 nanometres thickness may be deposited by sputtering, or a silver layer of 25 micrometres typical thickness may be applied by painting or spraying.

The following Examples illustrate the invention:

Several samples of piezoelectric cable were formed by co-extruding a central low melting point alloy

0146272

conductor and a polyvinylidine fluoride insulating layer surrounding the central conductor. The radius of the central conductor was approximately 0.42-0.48mm and the external radius of the insulating layer was approximately 1.3 to 1.5mm. The wires were stretched at a mean temperature of about 120°C to a draw ratio of 4:1 and were simultaneously poled by a corona discharge having a 35 kV potential difference. The resulting wires were provided with a 20 to 40 micrometre thick outer electrode using a silver paint sold under the trademark "Electrodag". The tensile modulus of the insulating polyvinylidine fluoride layer in the resulting cables was 2.1 GPa.

The composition used for the central conductors are shown in Table II, the dimensions of the cables are as shown in Table III and the piezoelectric response of the cables are shown in Table IV, from which it can be seen that the piezoelectric response increases significantly with increasing modulus of the central conductor.

## TABLE II

| Example | Composition (% by weight) | | | | | |
| | Bi | Sn | Pb | Cd | In | modulus(GPa) |
|---|---|---|---|---|---|---|
| 1 (comparison) |  | 42 |  | 14 | 44 | 0.312 |
| 2 (comparison) | 49 | 12 | 18 |  | 21 | 0.432 |
| 3 | 38 | 15 | 31 | 16 |  | 0.862 |
| 4 | 57 | 17 |  |  | 26 | 1.074 |

## TABLE III

| Example | Conductor radius(mm)(a) | $PVF_2$ external radius(mm)(b) | a/b | $PVF_2$ wall thickness(mm) |
|---|---|---|---|---|
| 1 (comparison) | 0.25 | 0.8 | 0.31 | 0.55 |
| 2 (comparison) | 0.25 | 0.80 | 0.31 | 0.54 |
| 3 | 0.22 | 0.74 | 0.30 | 0.52 |
| 4 | 0.24 | 0.75 | 0.32 | 0.51 |

## TABLE IV

| Example | Conductor modulus(GPa) | $PVF_2$ modulus minus conductor modulus(GPa) | $d_{3h}$ ($pCN^{-1}$) |
|---|---|---|---|
| 1 (comparison) | 0.312 | 1.79 | - 7.25 |
| 2 (comparison) | 0.432 | 1.67 | -10 |
| 3 | 0.862 | 1.24 | -13.5 |
| 4 | 1.074 | 1.03 | -12.5 |

0146272

CLAIMS:

1.       A piezoelectric coaxial cable, which comprises a central electrical conductor, an outer electrical conductor, and an intermediate insulating layer comprising a polymeric material that has been axially stretched and radially polarized to render it piezoelectric, the central conductor having a melting point below the melting or softening point of the intermediate layer and a tensile modulus of at least 0.45 GPa.

2.       A piezoelectric coaxial cable, which comprises a central electrical conductor, an outer electrical conductor, and an intermediate layer comprising a polymeric material, the central conductor and the intermediate layer having been axially stretched and the intermediate layer having been radially polarized to render it piezoelectric, the central conductor having a tensile modulus of at least 0.45 GPa.

3.       A cable as claimed in claim 1 or claim 2, wherein the tensile modulus of the central conductor has a value no smaller than 2.25 GPa below the tensile modulus of the intermediate layer.

4.       A cable as claimed in claim 2, wherein the tensile modulus of the central conductor has a value no smaller than 1.65 GPa below the tensile modulus of the intermediate layer.

5.       A piezoelectric coaxial cable, which comprises a central electrical conductor, an outer electrical conductor, and an insulating intermediate layer comprising a polymeric material that has been axially stretched and radially polarized to render it piezoelectric, the central conductor having a melting point below the melting or softening point of the intermediate layer and having a tensile modulus no smaller than 1.65 GPa below the tensile modulus of the intermediate layer.

6.      A piezoelectric coaxial cable, which comprises a central electrical conductor, an outer electrical conductor, and an intermediate layer comprising a polymeric piezoelectric material, the central conductor and the intermediate layer having been axially stretched and the intermediate layer having been radially polarized to render it piezoelectric, the central conductor having a minimum tensile modulus value of 1.65 GPa below the tensile modulus of the intermediate layer.

7.      A cable as claimed in any one of claims 1 to 6, wherein the intermediate layer comprises a vinylidine fluoride polymer.

8.      A cable as claimed in any one of claims 1 to 7, wherein the intermediate layer comprises polyvinylidine fluoride.

9.      A cable as claimed in any one of claims 1 to 8, wherein the central conductor is formed from a metal having a melting point of not more than 170°C and preferably a melting point within the range of from 50 to 150°C.

0146272

10.    A cable as claimed in claim 8 or claim 9, wherein the central conductor is formed from a metal that increases in volume as it solidifies from the melt.

11.    A method of forming a piezoelectric coaxial cable, which comprises the steps of:

(a)    forming a wire comprising a central electrical conductor that is capable of being stretched and has a tensile modulus of at least 0.45 GPa, the central conductor being surrounded by an insulating polymeric layer comprising a material that is capable of being rendered piezoelectric by being oriented and polarized;

(b)    axially stretching the wire to orient the insulating layer;

(c)    simultaneously with, or subsequent to, step (b), radially polarizing the insulating layer; and

(d)    providing the stretched wire with an outer electrical conductor.

12.    A method as claimed in claim 11, wherein the tensile modulus of the central conductor has a value no smaller than 2.25 GPa below the tensile modulus of the insulating layer.

13.    A method of forming a piezoelectric coaxial cable, which comprises the steps of :

0146272

(a)     forming a wire comprising a central electrical conductor that is capable of being stretched and, surrounding the central conductor, an insulating layer comprising a material that is capable of being rendered piezoelectric by being oriented and polarized;

(b)     axially stretching the wire to orient the insulating layer and to form a wire in which the central conductor has a tensile modulus no smaller than 1.65 GPa below the tensile modulus of the oriented insulating layer;

(c)     simultaneously with, or subsequent to, step (b), radially polarizing the insulating layer; and

(d)     providing the stretched wire with an outer electrical conductor.

14.     A method as claimed in any one of claims 10 to 13, wherein the central conductor comprises a metal that is caused to melt in order to enable it to stretch during step (b).

15.     A method as claimed in any one of claims 10 to 14, wherein steps (b) and (c) are conducted substantially simultaneously.

16.     A method as claimed in any one of claims 10 to 15, wherein the insulating layer is polarized by corona discharge.

17.     A method as claimed in any one of claims 10 to 16, wherein the wire is formed in step (a) by co-extruding the central conductor and the insulating layer.

18.     A method as claimed in any one of claims 10 to 17, wherein at least steps (b) and (c) are conducted as a continuous process in which wire formed in step (a) of indefinite length is passed through a heating zone in which the wire is heated to a predetermined elevated temperature, and the heated wire is passed through a stretching zone and a polarizing zone and then through a cooling zone, such that, at any instant, only a portion of the wire is at or above the predetermined elevated temperature.

19.     A method as claimed in any one of claims 10 to 18, wherein the insulating layer comprises a vinylidine fluoride polymer.

20.     A transducer which incorporates a cable as claimed in any one of claims 1 to 9 or a cable formed from a method as claimed in any one of claims 10 to 19.

Fig. 1.

Fig. 2.

# Fig. 3.